# EUROPEAN PATENT APPLICATION

(11) **EP 4 648 584 A1**
(43) Date of publication of application: **12.11.2025**
(21) Application number: 24916588.7
(22) Date of filing: 26.11.2024
(51) Int. Cl.: H10K 30/88, H10K 85/50, H10K 30/50

(54) **PACKAGING STRUCTURE FOR PEROVSKITE SOLAR CELL ASSEMBLY AND USE THEREOF**

(30) Priority: 08.01.2024 CN 202410025730
(71) Applicant: Xi'an TJ-Solar New Energy Co., Ltd, Xianyang, Shaanxi 712046 (CN)
(72) Inventor: LI, Peizhou, Xianyang, Shaanxi 712046 (CN); HAN, Wei, Xianyang, Shaanxi 712046 (CN)
(74) Representative: Novagraaf Technologies
(86) International application number: PCT/CN2024/134592
(87) International publication number: WO 2025/148538

(57) **Abstract**

The present invention belongs to the technical field of perovskite solar cells, and particularly relates to an encapsulation structure of a perovskite solar cell module and an application of an encapsulation structure of a perovskite solar cell module. The encapsulation structure includes a substrate, a transparent conductive layer, and a perovskite solar module sequentially from bottom to top, and further includes a encapsulation component in a housing structure and a encapsulation cover plate that are arranged on the transparent conductive layer. The perovskite solar module is arranged in an accommodating chamber of the encapsulation component with an inner wall in complete contact an outer wall. The encapsulation component includes a first inorganic layer, or organic layers and second inorganic layers that are circularly and repeatedly stacked on a first inorganic layer. In addition, the transparent conductive layer is composed of a left separated portion and a right separated portion, and an L-shaped metal electrode is merely in contact with a right side so as to prevent a short circuit between a first conductive portion and a second conductive portion. According to the encapsulation structure provided by the present disclosure, influence of water and oxygen on the cell can be effectively blocked through repeated sealing, thus improving stability and prolonging a service life of the cell.

## Description

### Technical Field

The present invention belongs to the technical field of perovskite solar cells, and particularly relates to an encapsulation structure of a perovskite solar cell module and an application of an encapsulation structure of a perovskite solar cell module.

### Background

With the deteriorating global ecological environment and escalating energy shortage, renewable energy has drawn widespread attention on account of its renewability and environmental friendliness. As a type of pure renewable energy, the solar energy has unparalleled advantages over other types of energy. The photovoltaic power generation technology has quickly become one of the technical means of effectively utilizing the solar energy since its advent. As the third generation of solar cells, perovskite solar cells have achieved efficiency of 25.5% in terms of laboratory small-area devices over just a dozen of years since their development in 2009. Compared with crystalline silicon solar cells with a market share of 90%, the perovskite solar cells are lower in cost while having efficiency equivalent to a certified record level of the crystalline silicon cells. However, the perovskite solar cells face a technical bottleneck in terms of long-term stability during their commercialization.

At present, the perovskite solar cells are likely to become unstable since metal electrodes and devices in cell modules will decompose due to moisture and oxygen in the air when in contact with the air. During encapsulation, the perovskite solar cell modules are generally disposed between upper and lower substrates, with encapsulation filler materials between the substrates and on the periphery of the cell. In addition, sealing materials are further provided on the peripheries of the substrates for further encapsulation. The vacuum-assisted thermal curing encapsulation process is usually adopted for the filler materials. However, the elevated temperatures during curing may induce decomposition of the perovskite layer. Then, a gap generated between contact portions induces entrance of water and oxygen. That is, water and oxygen will still probably enter the encapsulated cells from edges after encapsulation in the art known to inventors, damage perovskite material, decompose perovskite material, and finally shorten the lifespan of the encapsulated perovskite solar cell.

In view of this, the present invention is especially provided.

### Summary

An objective of the present invention is to overcome shortcomings of the art known to inventors and provide an encapsulation structure of a perovskite solar cell module and an application of an encapsulation structure of a perovskite solar cell module. An encapsulation component is mainly formed by a first inorganic layer or organic layers and second inorganic layers that are circularly and repeatedly stacked on a first inorganic layer. The encapsulation component encapsulates a top wall and side walls of a perovskite solar module simultaneously, and the perovskite solar cell module is multi-encapsulated repeatedly in a horizontal direction and a vertical direction, thus effectively protecting the perovskite solar cell module, reducing damage of moisture and oxygen to the cell, and improving stability of a cell and prolonging lifespan of the cell.

The objective of the present invention is achieved through the following technical solution:
In one aspect, the present invention provides an encapsulation structure of a perovskite solar cell module. The encapsulation structure of a perovskite solar cell module includes:
a substrate;
a transparent conductive layer, the transparent conductive layer is disposed on an upper part of the substrate;
a perovskite solar module, the perovskite solar module is disposed on an upper part of the transparent conductive layer;
an encapsulation component, the encapsulation component is disposed on the upper part of the transparent conductive layer, and the encapsulation component is in a form of a shell structure; the perovskite solar module is disposed in a hollow chamber of the shell structure of the encapsulation component, and an outer wall of the perovskite solar module is in contact with an inner wall of the encapsulation component; the encapsulation component includes a first inorganic layer, and the first inorganic layer is in contact with an upper surface of the transparent conductive layer; or the encapsulation component includes organic layers and second inorganic layers that are circularly and repeatedly stacked on the first inorganic layer, and both the first inorganic layer and the second inorganic layer are in contact with an upper surface of the transparent conductive layer; and
an encapsulation cover plate, the encapsulation cover plate is a box structure with a bottom opening, the encapsulation component is nested in a cavity of the box structure of the encapsulation cover plate, and the bottom opening of the box structure of the encapsulation cover plate is connected with the transparent conductive layer.

Preferably, the encapsulation cover plate is made of a transparent glass material.

Further, the first inorganic layer and the second inorganic layer are both composed of an oxide thin film or a nitride thin film. That is, the first inorganic layer and the second inorganic layer are a type of encapsulation thin film made from an inorganic material and used for isolating an impurity such as water and oxygen. For example, the oxide thin film may be any one of Al₂O₃, SiO₂, HfO₂, ZrO₂, ZnO, Ta₂O₅, CeO₂, La₂O₃, CoOₓ, MoO₃, SrTiO, TiO₂, SnO₂, Nb₂O₅, Y₂O₃, MgO, BaTiO₃, In₂O₃, NiO, V₂O₅ and WO₃. The nitride thin film may be either silicon nitride or aluminum nitride. The organic layer is made from acrylic resin, epoxy acrylate or epoxy resin. That is, the organic layer is an encapsulation thin film made from an organic material and used for isolating an impurity such as water and oxygen.

Further, a thickness of the first inorganic layer and a thickness of the second inorganic layer are both 5 nm to 10 µm, and a thickness of the organic layer is 10 nm to 100 µm.

It should be noted that the thickness of the first inorganic layer and the thickness of the second inorganic layer may be manufactured adaptively according to actual encapsulation demand, and may be selected from 5 nm, 20 nm, 40 nm, 80 nm, 100 nm, 300 nm, 500 nm, 700 nm, 900 nm, 1000 nm, 2 µm, 4 µm, 6 µm, 8 µm, 10 µm, etc., which will not be enumerated. The thickness of the organic layer may also be manufactured adaptively as 10 nm, 50 nm, 100 nm, 300 nm, 600 nm, 800 nm, 1000 nm, 2 µm, 10 µm, 30 µm, 50 µm, 60 µm, 80 µm or 100 µm according to actual encapsulation demand, which will not be enumerated.

Further, the first inorganic layer includes a first inorganic layer top portion disposed horizontally, first inorganic layer side portions disposed vertically and connected with a periphery of the first inorganic layer top portion, and first inorganic layer bottom portions connected with bottom ends of first inorganic layer side portions and horizontally extending outwards; and
a lower surface of the first inorganic layer top portion is in intimate contact with an upper surface of the perovskite solar module, inner walls of four first inorganic layer side portions are in intimate contact with outer walls at front, back, left and right of the perovskite solar module respectively, and lower surfaces of four first inorganic layer bottom portions are in intimate contact with the upper surface of the transparent conductive layer.

Further, the organic layer includes an organic layer top portion disposed horizontally, organic layer side portions disposed vertically and connected with a periphery of the organic layer top portion, and organic layer bottom portions connected with bottom ends of organic layer side portions and horizontally extending outwards; and
a lower surface of the organic layer top portion is in intimate contact with an upper surface of the first inorganic layer top portion, inner walls of four organic layer side portions are in intimate contact with outer walls at front, back, left and right of the first inorganic layer side portions respectively, lower surfaces of four organic layer bottom portions are in intimate contact with upper surfaces of the first inorganic layer bottom portions, and an outward extension length of the organic layer bottom portion is less than an outward extension length of the first inorganic layer bottom portion.

Further, the second inorganic layer includes a second inorganic layer top portion disposed horizontally, second inorganic layer side portions disposed vertically and connected with a periphery of the second inorganic layer top portion, and second inorganic layer bottom portions connected with bottom ends of second inorganic layer side portions and horizontally extending outwards; and
a lower surface of the second inorganic layer top portion is in intimate contact with an upper surface of the organic layer top portion, inner walls of four second inorganic layer side portions are in intimate contact with outer walls at the front, back, left and right of the organic layer side portions respectively, and the four second inorganic layer bottom portions encapsulates the first inorganic layer bottom portions and the organic layer bottom portions correspondingly and is in intimate contact with the upper surface of the transparent conductive layer.

Further, the first inorganic layer and the second inorganic layer are made through any one or a combination of chemical vapor deposition, plasma-enhanced chemical vapor deposition, sputtering or sublimation, and the organic layer is a polymeric thin film that is formed by coating an ink composition onto a substrate through inkjet printing, spraying, roller coating, blade coating or spin coating and performing curing through heating or ultraviolet exposure.

Further, the perovskite solar module includes an electron transport layer, a perovskite absorber layer, and a hole transport layer that are sequentially stacked and connected with each other; and
the electron transport layer is connected with the transparent conductive layer, or the hole transport layer is connected with the transparent conductive layer.

Further, a first conductive portion and a second conductive portion are disposed on a surface of the transparent conductive layer and at two opposite sides of the encapsulation cover plate, and a gap is reserved between the encapsulation cover plate and each of the first conductive portion and the second conductive portion;
the transparent conductive layer further includes an L-shaped metal electrode structure, and the metal electrode structure is composed of a first metal electrode disposed horizontally and a second metal electrode disposed vertically and connected with an end portion of the first metal electrode; and
the transparent conductive layer is mainly composed of two separated portions, the first metal electrode is disposed on an upper surface of the perovskite solar module and is in contact with a lower surface of the encapsulation component, the second metal electrode is in intimate contact with any side surface of the perovskite solar module, and an end of the second metal electrode is in contact with an upper surface of one transparent conductive layer of the two separated portions.

In addition, the present invention provides an encapsulation method of a perovskite solar cell module. The encapsulation method is used for implementing the above encapsulation structure of a perovskite solar cell module, and includes: sequentially manufacturing a transparent conductive layer and a perovskite solar module on a substrate; disposing an encapsulation component on the transparent conductive layer and on a periphery of the perovskite solar module, and an outer wall of the perovskite solar module is in contact with an inner wall of the encapsulation component; and disposing an encapsulation cover plate on the transparent conductive layer and on a periphery of the encapsulation component.

In the other aspect, the present invention provides an application of the encapsulation structure to a solar cell.

Compared with the art known to inventors, the present invention has the following beneficial effects:
According to the encapsulation structure provided by the present invention, the encapsulation component is mainly formed by the first inorganic layer or the organic layers and the second inorganic layers that are circularly and repeatedly stacked on the first inorganic layer. The encapsulation component encapsulates the top wall and the side walls of the perovskite solar module simultaneously, and the perovskite solar module is multi-encapsulated repeatedly in the horizontal direction and the vertical direction. In addition, the encapsulation component has features of dense structure, chemical inertness and high chemical stability of an inorganic barrier film, and combined with the multiple protection of the encapsulation cover plate, such that influence of the moisture and the oxygen on the perovskite cell can be effectively avoided. The encapsulation structure is especially suitable for encapsulating a perovskite material more sensitive to the moisture, and avoids the ingress of moisture, which can lead to the decomposition of perovskite due to suboptimal encapsulation performance, thus improving the stability of the perovskite solar cell and prolonging the lifespan of the perovskite solar cell. In addition, the encapsulation structure has a simple process, high encapsulation efficiency and an excellent encapsulation effect on a large-area perovskite cell.

### Brief Description of the Drawings

The drawings herein are incorporated into the description as a constituent part of the description, and serve to explain principles of the present invention along with the description.

To describe the technical solutions in examples of the present invention or in the art known to inventors more clearly, accompanying drawings required in explanations of the examples or in the art known to inventors will be briefly introduced below. Apparently, a person skilled in the art can still derive other accompanying drawings from these accompanying drawings without creative efforts.
Fig. 1 illustrates a schematic diagram of an encapsulation structure with a multi-layer encapsulation component according to the present invention;
Fig. 2 illustrates a schematic diagram of an encapsulation structure with a three-layer encapsulation component according to Example 1 of the present invention;
Fig. 3 illustrates a schematic diagram of an encapsulation structure with a five-layer encapsulation component according to Example 2 of the present invention;
Fig. 4 illustrates a schematic diagram of an encapsulation structure with a one-layer encapsulation component according to Example 3 of the present invention;
Fig. 5 illustrates a schematic diagram of an encapsulation structure with a three-layer encapsulation component (three layers are flush in a longitudinal direction and not encapsulated) according to Comparative Example 1;
Fig. 6 illustrates a schematic diagram of an encapsulation structure without a cover plate component according to Comparative Example 2;
Fig. 7 illustrates a schematic diagram of an encapsulation structure without an encapsulation component according to Comparative Example 3; and
Fig. 8 illustrates change curves of normalization efficiency along with time of encapsulation structures of a perovskite solar cell according to examples and comparative examples.

In the figures:
10, substrate;
20, transparent conductive layer; 21, first conductive portion; 22, second conductive portion; 23, metal electrode structure; 23-1, first metal electrode; 23-2, second metal electrode;
30, perovskite solar module; 31, electron transport layer; 32, perovskite absorber layer; 33, hole transport layer;
40, encapsulation component; 41, first inorganic layer; 41-1, first inorganic layer top portion; 41-2, first inorganic layer side portion; 41-3, first inorganic layer bottom portion; 42, organic layer; 42-1, organic layer top portion; 42-2, organic layer side portion; 42-3, organic layer bottom portion; 43, second inorganic layer; 43-1, second inorganic layer top portion; 43-2, second inorganic layer side portion; 43-3, second inorganic layer bottom portion; and
50, encapsulation cover plate.

### Detailed Description of the Embodiments

Illustrative examples will be described in detail herein, and their instances are shown in the accompanying drawings. When the following description involves the accompanying drawings, the same numerals in different accompanying drawings indicate the same or similar elements unless otherwise indicated. Embodiments described in the following illustrative examples do not represent all embodiments consistent with the present invention. On the contrary, these embodiments are merely instances of apparatuses that are detailed in the appended claims and consistent with some aspects of the present invention.

In order to make a person skilled in the art better understand and implement the technical solution of the present invention, the present invention will be described in detail below with reference to accompanying drawings and specific examples. The following examples are merely used to describe the technical solution of the present invention rather than limit the protection scope of the present invention.

In the description of the present invention, it should be noted that the orientation or positional relations indicated by the terms "center", "longitudinal", "lateral", "length", "width", "thickness", "up", "down", "front", "rear", "left", "right", "vertical", "horizontal", "top", "bottom", "inside", "outside", "axial", "radial", "circumferential" etc. are based on the orientation or positional relation shown in the accompanying drawings, are merely for facilitating the description of the technical solution of the present invention and simplifying the description, rather than indicating or implying that an apparatus or element referred to must have a specific orientation or be constructed and operated in a specific orientation, and thus cannot be interpreted as limitation to the present invention.

Terms used in the present invention are merely used for describing specific examples rather than limiting the present invention. Unless otherwise defined, technical terms or scientific terms used in the present invention should have ordinary meanings understood by those of skilled in the art to which the present invention belongs. Similar words such as "a", "an" or "one" used in the description and the claims of the present invention do not indicate quantity limitation, but indicate existence of at least one. In addition, the terms "first", "second", etc. are merely used for describing purposes and cannot be understood as indicating or implying relative importance. In the description of the present invention, it should be noted that unless otherwise explicitly specified or defined, the terms such as "connected" and "connection" should be understood in a broad sense. For example, they can denote a fixed connection, a detachable connection or an integrated connection, can denote a mechanical connection or an electric connection, or can denote a direct connection or an indirect connection through an intermediate medium. Those of skilled in the art can understand specific meanings of the above terms in the present invention based on a specific situation. In the description of the present invention, unless otherwise specified, "plurality" means two or more, which will not be detailed herein.

### Example 1

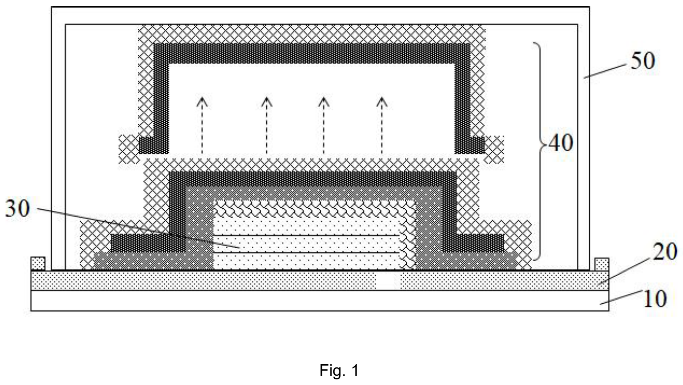

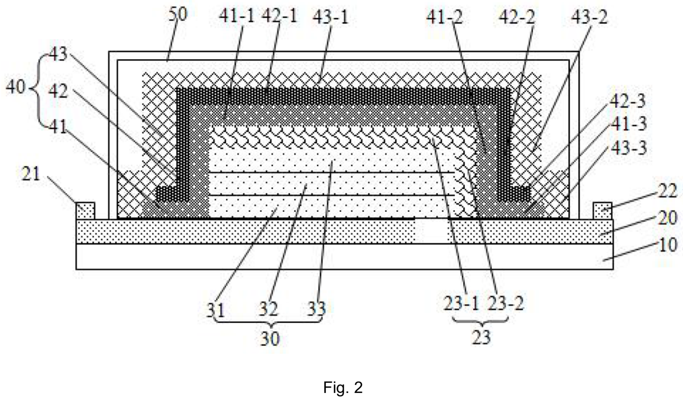

As shown in Fig. 1 and Fig. 2, the present invention provides an encapsulation structure of a perovskite solar cell module. The encapsulation structure of a perovskite solar cell module includes a substrate 10, and a transparent conductive layer 20 and a perovskite solar module 30 that are sequentially disposed on the substrate 10 from bottom to top. The encapsulation structure of a perovskite solar cell module further includes an encapsulation component 40 disposed on the transparent conductive layer 20, and the encapsulation component 40 is in a form of a shell structure. The perovskite solar module 30 is disposed in a hollow chamber of the shell structure of the encapsulation component 40, and an outer wall of the perovskite solar module 30 is in contact with an inner wall of the encapsulation component 40. The encapsulation component 40 may include a first inorganic layer 41, and the first inorganic layer 41 is in contact with an upper surface of the transparent conductive layer 20; or the encapsulation component 40 includes organic layers 42 and second inorganic layers 43 that are circularly and repeatedly stacked on a first inorganic layer 41, and both the first inorganic layer 41 and the second inorganic layer 43 are in contact with an upper surface of the transparent conductive layer 20.

Specifically, the encapsulation component 40 of the present disclosure may include a one-layer structure (that is, merely a first inorganic layer 41 exists), a three-layer structure (the first inorganic layer 41/the organic layer 42/the second inorganic layer 43), a five-layer structure (the first inorganic layer 41/the organic layer 42/the second inorganic layer 43/the organic layer 42/the second inorganic layer 43), a seven-layer structure (the first inorganic layer 41/the organic layer 42/the second inorganic layer 43/the organic layer 42/the second inorganic layer 43/the organic layer 42/the second inorganic layer 43) and so on. As shown in Fig. 1, the encapsulation component 40 may have 21 layers at most, a specific number of layers may be according to actual production demand, and the inorganic layers and the organic layers are sequentially stacked. When a number of layers of the encapsulation component 40 is greater than or equal to three, an outermost layer is an inorganic layer, and the organic layer 42 is used to compensate for a defect of the inorganic layer, relieve stress and facilitate adhesive encapsulation. The encapsulation structure of a perovskite solar cell after encapsulation may be laminated by a laminator and then integrally formed.

A thickness of the first inorganic layer 41 and a thickness of the second inorganic layer 43 are both 5 nm to 10 µm, and a thickness of the organic layer 42 is 10 nm to 100 µm, which may be selected specifically according to actual conditions. Each of the first inorganic layer 41 and the second inorganic layer 43 is composed of an oxide thin film or a nitride thin film. That is, the first inorganic layer 41 and the second inorganic layer 43 are a type of encapsulation thin film made from an inorganic material and used for isolating an impurity such as moisture and oxygen. Specifically, the oxide thin film may be any one of Al₂O₃, SiO₂, HfO₂, ZrO₂, ZnO, Ta₂O₅, CeO₂, La₂O₃, CoOₓ, MoO₃, SrTiO, TiO₂, SnO₂, Nb₂O₅, Y₂O₃, MgO, BaTiO₃, In₂O₃, NiO, V₂O₅ or WO₃. The nitride thin film may be silicon nitride or aluminum nitride. The organic layer is made from acrylic resin, epoxy acrylate or epoxy resin. That is, the organic layer is an encapsulation thin film made from an organic material and used for isolating an impurity such as moisture and oxygen.

Preferably, the first inorganic layer 41 and the second inorganic layer 43 are made through any one or a combination of chemical vapor deposition, plasma-enhanced chemical vapor deposition, sputtering or sublimation, and the organic layer 42 is a polymeric thin film that is formed by coating an ink composition onto a substrate through inkjet printing, spraying, roller coating, blade coating or spin coating and performing curing through heating or ultraviolet exposure. The advantages of the organic layer 42 are to provide planarization and compensate for an internal defect of the inorganic layer, and eliminate influence of moisture infiltration from a side edge of the encapsulation component 40.

Preferably, the encapsulation structure of the example of the present invention further includes an encapsulation cover plate 50, and the encapsulation cover plate may be made of a transparent glass material. The encapsulation cover plate 50 is a box structure with a bottom opening, the encapsulation component 40 is overall nested in a cavity of the box structure of the encapsulation cover plate 50, and the bottom opening of the box structure of the encapsulation cover plate 50 is connected with the transparent conductive layer 20.

The perovskite solar module 30 of the example of the present invention includes an electron transport layer 31, a perovskite absorber layer 32, and a hole transport layer 33 that are sequentially stacked and connected with each other. The electron transport layer 31 is connected with the transparent conductive layer 20, or the hole transport layer 33 is connected with the transparent conductive layer 20. That is, the perovskite solar module 30 has two stacking cases from bottom to top as follows: a first stacking case of the electron transport layer 31, the perovskite absorber layer 32 and the hole transport layer 33 and a second stacking case of the hole transport layer 33, the perovskite absorber layer 32 and the electron transport layer 31.

Preferably, the transparent conductive layer 20 in the example of the present invention is made from but not limited to one or more of indium tin oxide (ITO), aluminum-doped zinc oxide (AZO), indium-doped zinc oxide (IZO), fluorine-doped tin oxide (FTO), tungsten doped indium oxide (IWO), cerium-doped indium oxide (ICO) and Ag nanowires with a thickness selected from 100 nm to 400 nm.

As shown in Fig. 2, the example of the present invention will be described in detail with the three-layer structure (the first inorganic layer 41/the organic layer 42/the second inorganic layer 43) as an example as follows:
The first inorganic layer 41 includes a first inorganic layer top portion 41-1 disposed horizontally, first inorganic layer side portions 41-2 disposed vertically and connected with a periphery of the first inorganic layer top portion 41-1, and first inorganic layer bottom portions 41-3 connected with bottom ends of first inorganic layer side portions 41-2 and horizontally extending outwards. A lower surface of the first inorganic layer top portion 41-1 is in intimate contact with an upper surface of the perovskite solar module 30, inner walls of four first inorganic layer side portions 41-2 are in intimate contact with outer walls at front, back, left and right of the perovskite solar module 30 respectively, and lower surfaces of four first inorganic layer bottom portions 41-3 are in intimate contact with the upper surface of the transparent conductive layer 20.

The organic layer 42 includes an organic layer top portion 42-1 disposed horizontally, organic layer side portions 42-2 disposed vertically and connected with a periphery of the organic layer top portion 41-1, and organic layer bottom portions 42-3 connected with bottom ends of organic layer side portions 42-2 and horizontally extending outwards. A lower surface of the organic layer top portion 42-1 is in intimate contact with an upper surface of the first inorganic layer top portion 41-1, inner walls of four organic layer side portions 42-2 are in intimate contact with outer walls at front, back, left and right of the first inorganic layer side portions 41-2 respectively, lower surfaces of four organic layer bottom portions 42-3 are in intimate contact with upper surfaces of the first inorganic layer bottom portions 41-3, and an outward extension length of the organic layer bottom portion 42-3 is less than an outward extension length of the first inorganic layer bottom portion 41-3.

The second inorganic layer 43 includes a second inorganic layer top portion 43-1 disposed horizontally, second inorganic layer side portions 43-2 disposed vertically and connected with a periphery of the second inorganic layer top portion 43-1, and second inorganic layer bottom portions 43-3 connected with bottom ends of second inorganic layer side portions 43-2 and horizontally extending outwards. A lower surface of the second inorganic layer top portion 43-1 is in intimate contact with an upper surface of the organic layer top portion 42-1, inner walls of four second inorganic layer side portions 43-2 are in intimate contact with outer walls at front, back, left and right of the organic layer side portions 42-2 respectively, and the four second inorganic layer bottom portions 43-3 encapsulates the first inorganic layer bottom portions 41-3 and the organic layer bottom portions 42-3 correspondingly and is in intimate contact with the upper surface of the transparent conductive layer 20.

In addition, it should be noted that according to the present invention, a first conductive portion 21 and a second conductive portion 22 are disposed on a surface of the transparent conductive layer 20 and at a left side and a right side of the encapsulation cover plate 50, and a gap is reserved between each of the first conductive portion 21 and the second conductive portion 22 and the encapsulation cover plate 50. Further, the transparent conductive layer 20 further includes an L-shaped metal electrode structure 23, and the metal electrode structure 23 is composed of a first metal electrode 23-1 disposed horizontally and a second metal electrode 23-2 disposed vertically and connected with an end portion of the first metal electrode 23-1. The first metal electrode 23-1 is disposed on the upper surface of the perovskite solar module 30 and is in contact with a lower surface of the encapsulation component 40, the second metal electrode 23-2 is in intimate contact with any side surface of the perovskite solar module 30, and an end of the second metal electrode 23-2 is in contact with the upper surface of one transparent conductive layer 20 of the two separated portions. That is, as shown in Fig. 2, a bottom end of the second metal electrode 23-2 is merely in contact with the upper surface of the right transparent conductive layer 20. Thus, a gap generated between contact portions can be prevented from inducing entrance of the moisture and the oxygen, thus further improving stability of the perovskite solar cell and prolonging lifespan of the perovskite solar cell.

Preferably, the metal electrode structure 23 is made from a metal material or a composite material. The metal material is a single metal material or an alloy material. The single metal material may be any one of metals such as Au, Ag, Ca, Mg, Al, and so on. The alloy material may be at least two of Au, Ag, Ca, Mg and Al. The composite material may be a composite material formed by the metal material and at least one of C, graphene, and carbon nanotubes.

As an embodiment of the present invention, an inductively coupled plasma enhanced chemical vapor deposition device (ICP-PECVD) is selected to sequentially form the first inorganic layer 41, the organic layer 42 and the second inorganic layer 43 on the surface of PET, thus greatly simplifying operation steps of the encapsulation component 40, reducing device cost and shortening a processing period, and effectively reducing a production cost. In addition, the process is performed at a low temperature (<100°C) without damaging the substrate 10.

Specifically, with the encapsulation structure of this embodiment being a three-layer structure as an example, the transparent conductive layer 20 of the perovskite solar cell is conductive glass with a thickness of 135 nm. The electron transport layer 31 is formed by vacuum-evaporating an electron transport material carbon-60 (C₆₀) on the ITO substrate 20 and has a thickness of 40 nm. The electron transport layer 31 is spin-coated with the perovskite absorber layer 32(CH₃NH₃PbI₃) with a thickness of 600 nm. The electron transport layer 31 is spin-coated with the hole transport layer 33 made from a nickel oxide material, and a thickness of the hole transport layer 33 is 20 nm. A silver electrode (a cathode electrode) is vacuum-evaporated on the hole transport layer 33 with a thickness of 100 nm. An effective area of the cell is 0.64 cm².

The thickness of the three-layer structure in the encapsulation component 40 is as follows: the thickness of the first inorganic layer 41 is 40 nm, the thickness of the organic layer 42 is 50 µm, and the thickness of the second inorganic layer 43 is 40 nm.

In addition, the encapsulation structure provided by the present invention may be applied to encapsulation other types of solar cells.

### Example 2

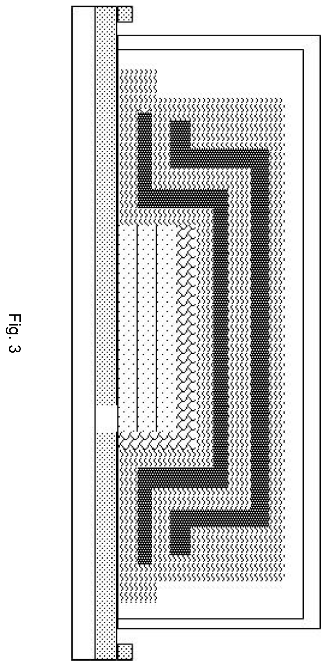

As shown in Fig. 3, an encapsulation structure of a perovskite solar cell module according to this example is different from Example 1 merely in that the encapsulation component 40 of this example adopts a five-layer structure, and the thicknesses of the respective layers are as follows: a first inorganic layer 41 (40 nm)/an organic layer 42 (50 µm)/a second inorganic layer 43 (40 nm)/an organic layer 42 (50 µm)/a second inorganic layer 43 (40 nm).

### Example 3

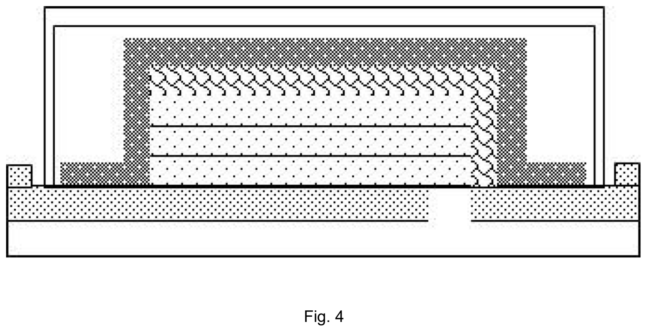

As shown in Fig. 4, an encapsulation structure of a perovskite solar cell module according to this example is different from Example 1 merely in that an encapsulation component 40 of this example has merely one inorganic layer 41 (with a thickness of 100 nm).

### Comparative Example 1

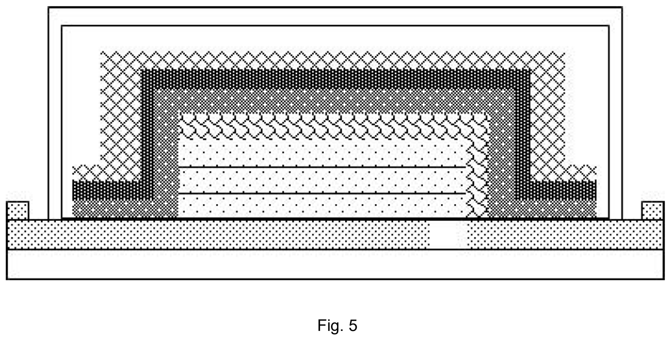

As shown in Fig. 5, an encapsulation structure of a perovskite solar cell module according to this comparative example is different from Example 1 merely in that an encapsulation component 40 of this example also adopts a three-layer structure, but an organic layer bottom portion 42-3 is flush with a first inorganic layer bottom portion 41-3 and a second inorganic layer bottom portion 43-3 in a longitudinal direction.

### Comparative Example 2

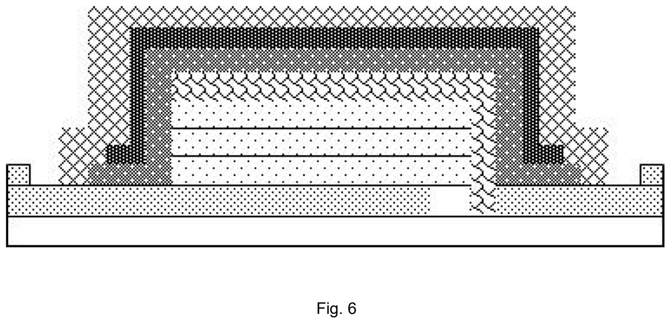

As shown in Fig. 6, an encapsulation structure of a perovskite solar cell module according to this comparative example is different from Example 1 merely in that in the encapsulation structure of this comparative example, no encapsulation cover plate 50 is added.

### Comparative Example 3

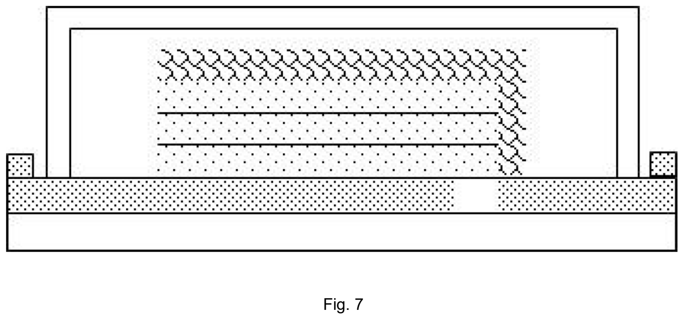

As shown in Fig. 7, an encapsulation structure of a perovskite solar cell module according to this comparative example is different from Example 1 merely in that in the encapsulation structure of this comparative example, no first inorganic layer 41/organic layer 42/second inorganic layer 43 is added.

### Test method:

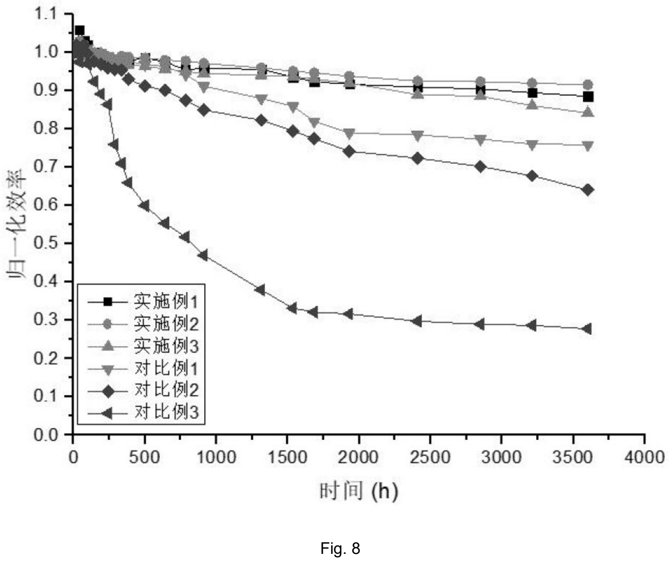

PCE-t curves (curves of normalization efficiency change along with time) of examples and comparative examples are tested by a solar simulator. An illumination intensity of the solar simulator is 100 mA/cm², and experimental conditions include illumination at atmospheric pressure, a temperature of 20°C and humidity of 30%. The test results are shown in Fig. 8.

Through the test results of the examples and the comparative examples in Fig. 8, it is found that the encapsulation structure according to the present invention has more excellent photostability, can inhibit decomposition of the perovskite material, and improve the stability of the perovskite cell and prolong the lifespan of the perovskite cell.

By adding the encapsulation component 40, hydrothermal stability of the encapsulation structure of a perovskite solar cell module can be significantly improved. From the test results of Example 1 to Example 3, it can be seen that the encapsulation component 40 of the present invention has a more excellent encapsulation effect when used for encapsulation the perovskite cell, and the hydrothermal stability of the encapsulation structure of a perovskite cell is significantly improved. When placed in air for 3600 h, an encapsulation effect (reaching 90% of initial power conversion efficiency) of the encapsulation component 40 with the five-layer structure is better than an encapsulation effect of the encapsulation module 40 with the three-layer structure (achieving about 88% of the initial power conversion efficiency) and better than an encapsulation effect (achieving about 84% of the initial power conversion efficiency) of encapsulation module 40 with the one-layer structure.

The comparison between results of Example 1 and Comparative Example 1 shows that an encapsulation effect (achieving about 60% of the initial power conversion efficiency) of a method by which the organic layer bottom portion 42-3 is flush with the first inorganic layer bottom portion 41-3 and the second inorganic layer bottom portion 43-3 in Comparative Example 1 is worse than an encapsulation effect (achieving about 88% of the initial power conversion efficiency) of a method by which the first inorganic layer 41 and the second inorganic layer 43 cover and wrap around the organic layer 42 in Example 1.

However, the result of Comparative Example 2 shows that hydrothermal stability is reduced without adding the cover plate assembly 50, and the initial power conversion efficiency is about 70%. However, in Comparative Example 3, hydrothermal stability of the encapsulation structure of a perovskite cell is obviously reduced without adding the encapsulation component 40, and initial power conversion efficiency is less than 3%.

The embodiments described above are merely specific embodiments of the present invention for those skilled in the art to understand or implement the present invention. Many modifications to these examples will be apparent to those skilled in the art, and the general principles defined herein can be implemented in other examples without departing from the spirit or scope of the present invention.

It should be noted that the present invention is not limited to contents described above, and various modifications and changes can be made without departing from the scope of the present invention. The scope of the present invention is merely limited by the appended claims.

## Claims

1. An encapsulation structure of a perovskite solar cell module, comprising:
a substrate (10);
a transparent conductive layer (20), wherein the transparent conductive layer (20) is disposed on an upper part of the substrate (10);
a perovskite solar module (30), wherein the perovskite solar module (30) is disposed on an upper part of the transparent conductive layer (20);
an encapsulation component (40), wherein the encapsulation component (40) is disposed on the upper part of the transparent conductive layer (20), and the encapsulation component (40) is in a form of a shell structure; the perovskite solar module (30) is disposed in a hollow chamber of the shell structure of the encapsulation component (40), and an outer wall of the perovskite solar module (30) is in contact with an inner wall of the encapsulation component (40); the encapsulation component (40) comprises a first inorganic layer (41), and
the first inorganic layer (41) is in contact with an upper surface of the transparent conductive layer (20); or the encapsulation component (40) comprises organic layers (42) and second inorganic layers (43) that are circularly and repeatedly stacked on the first inorganic layer (41), and both the first inorganic layer (41) and the second inorganic layer (43) are in contact with an upper surface of the transparent conductive layer (20); and
an encapsulation cover plate (50), wherein the encapsulation cover plate (50) is a box structure with a bottom opening, the encapsulation component (40) is nested in a cavity of the box structure of the encapsulation cover plate (50), and the bottom opening of the box structure of the encapsulation cover plate (50) is connected with the transparent conductive layer (20).

2. The encapsulation structure of a perovskite solar cell module according to claim 1, wherein the first inorganic layer (41) and the second inorganic layers (43) are both composed of an oxide thin film or a nitride thin film, and the organic layer (42) is made from acrylic resin, epoxy acrylate or epoxy resin.

3. The encapsulation structure of a perovskite solar cell module according to claim 1, wherein a thickness of the first inorganic layer (41) and a thickness of the second inorganic layers (43) are both 5 nm to 10 µm, and a thickness of the organic layers (42) is 10 nm to 100 µm.

4. The encapsulation structure of a perovskite solar cell module according to claim 1, wherein the first inorganic layer (41) comprises a first inorganic layer top portion (41-1) disposed horizontally, first inorganic layer side portions (41-2) disposed vertically and connected with a periphery of the first inorganic layer top portion (41-1), and first inorganic layer bottom portions (41-3) connected with bottom ends of first inorganic layer side portions (41-2) and horizontally extending outwards; and
a lower surface of the first inorganic layer top portion (41-1) is in intimate contact with an upper surface of the perovskite solar module (30), inner walls of four first inorganic layer side portions (41-2) are in intimate contact with outer walls at front, back, left and right of the perovskite solar module (30) respectively, and lower surfaces of four first inorganic layer bottom portions (41-3) are in intimate contact with the upper surface of the transparent conductive layer (20).

5. The encapsulation structure of a perovskite solar cell module according to claim 4, wherein the organic layers (42) comprises an organic layer top portion (42-1) disposed horizontally, organic layer side portions (42-2) disposed vertically and connected with a periphery of the organic layer top portion (41-1), and organic layer bottom portions, connected with bottom ends of organic layer side portions (42-2) and horizontally extending outwards; and
a lower surface of the organic layer top portion (42-1) is in intimate contact with an upper surface of the first inorganic layer top portion (41-1), inner walls of four organic layer side portions (42-2) are in intimate contact with outer walls at front, back, left and right of the first inorganic layer side portions (41-2) respectively, lower surfaces of four organic layer bottom portions (42-3) are in intimate contact with upper surfaces of the first inorganic layer bottom portions (41-3), and an outward extension length of the organic layer bottom portion (42-3) is less than an outward extension length of the first inorganic layer bottom portion (41-3).

6. The encapsulation structure of a perovskite solar cell module according to claim 5, wherein the second inorganic layer (43) comprises a second inorganic layer top portion (43-1) disposed horizontally, second inorganic layer side portions (43-2) disposed vertically and connected with a periphery of the second inorganic layer top portion (43-1), and second inorganic layer bottom portions (43-3) connected with bottom ends of second inorganic layer side portions (43-2) and horizontally extending outwards; and
a lower surface of the second inorganic layer top portion (43-1) is in intimate contact with an upper surface of the organic layer top portion (42-1), inner walls of four second inorganic layer side portions (43-2) are in intimate contact with outer walls at front, back, left and right of the organic layer side portions (42-2) respectively, and four second inorganic layer bottom portions (43-3) encapsulates the first inorganic layer bottom portions (41-3) and the organic layer bottom portions (42-3) correspondingly and is in intimate contact with the upper surface of the transparent conductive layer (20).

7. The encapsulation structure of a perovskite solar cell module according to claim 5, wherein the first inorganic layer (41) and the second inorganic layers (43) are made through any one or a combination of chemical vapor deposition, plasma-enhanced chemical vapor deposition, sputtering or sublimation, and the organic layer (42) is a polymeric thin film that is formed by coating an ink composition onto a substrate through inkjet printing, spraying, roller coating, blade coating or spin coating and performing curing through heating or ultraviolet exposure.

8. The encapsulation structure of a perovskite solar cell module according to any one of claims 1 to 7, wherein the perovskite solar module (30) comprises an electron transport layer (31), a perovskite absorber layer (32), and a hole transport layer (33) that are sequentially stacked and connected with each other; and
the electron transport layer (31) is connected with the transparent conductive layer (20), or the hole transport layer (33) is connected with the transparent conductive layer (20).

9. The encapsulation structure of a perovskite solar cell module according to claim 8, wherein a first conductive portion (21) and a second conductive portion (22) are disposed on a surface of the transparent conductive layer (20) and at two opposite sides of the encapsulation cover plate (50), and a gap is reserved between the encapsulation cover plate and each of the first conductive portion (21) and the second conductive portion;
further comprises an L-shaped metal electrode structure (23), and the metal electrode structure is composed of a first metal electrode (23-1) disposed horizontally and a second metal electrode (23-2) disposed vertically and connected to an end portion of the first metal electrode (23-1); and the transparent conductive layer (20) is mainly composed of two separated portions, the first metal electrode (23-1) is disposed on an upper surface of the perovskite solar module (30) and is in contact with a lower surface of the encapsulation component (40), the second metal electrode (23-2) is in intimate contact with any side surface of the perovskite solar module (30), and an end of the second metal electrode (23-2) is in contact with an upper surface of one transparent conductive layer (20) of the two separated portions.

10. An application of the encapsulation structure according to any one of claims 1 to 9 to a solar cell.
